# EUROPEAN PATENT APPLICATION

(11) **EP 4 468 329 A1**
(43) Date of publication of application: **27.11.2024**
(21) Application number: 22923836.5
(22) Date of filing: 27.01.2022
(51) Int. Cl.: H01L 21/677

(54) **SUBSTRATE PROCESSING APPARATUS AND SUBSTRATE PROCESSING METHOD**

(71) Applicant: Tokyo Electron Limited, Tokyo 107-6325 (JP)
(72) Inventor: HAYAKAWA, Susumu, Kikuchi-gun, Kumamoto 869-1232 (JP); KITANO, Junichi, Tokyo 107-6325 (JP); SEKIGUCHI, Kenji, Nirasaki-shi, Yamanashi 407-0192 (JP); YONEZAWA, Syuhei, Nirasaki-shi, Yamanashi 407-0192 (JP); KONDO, Yoshihiro, Koshi-shi, Kumamoto 861-1116 (JP)
(74) Representative: Manitz Finsterwald Patent- und Rechtsanwaltspartnerschaft mbB
(86) International application number: PCT/JP2022/003161
(87) International publication number: WO 2023/144971

(57) **Abstract**

A substrate processing apparatus includes a substrate cleaning device; a chip cleaning device; a chip bonding device; a transfer section; a first substrate transfer arm; and a first frame transfer arm. The substrate cleaning device is configured to clean a substrate. The chip cleaning device is configured to clean multiple chips in a state where the multiple chips are attached to a frame via a tape. The chip bonding device is configured to bond the multiple chips to different bonding regions of a main surface of the substrate. The transfer section is adjacent to the substrate cleaning device, the chip cleaning device, and the chip bonding device. The first substrate transfer arm is configured to hold and transfer the substrate in the transfer section. The first frame transfer arm is configured to hold the frame and transfer the frame together with the multiple chips in the transfer section. The first substrate transfer arm transfers the substrate from the substrate cleaning device to the chip bonding device, and the first frame transfer arm transfers the multiple chips together with the frame from the chip cleaning device to the chip bonding device.

## Description

### TECHNICAL FIELD

The various aspects and embodiments described herein pertain generally to a substrate processing apparatus and a substrate processing method.

### BACKGROUND

A chip mounting system described in Patent Document 1 is equipped with a chip supply device, a bonding device, a surface processing device, a carry-in/out unit, and a transfer unit (paragraph [0225] of Patent Document 1). The chip supply device holds a plurality of chips to be bonded and supplies the chips individually. The bonding device mounts, onto a substrate, the chips supplied from the chip supply device. The surface processing device performs a surface activation processing and a hydrophilization processing onto the plurality of chips and a bonding surface of the substrate. The carry-in/out unit carries the chips and the substrate, which are to be bonded to each other, from the outside of the chip mounting system into the system, and carries the substrate on which the chips are mounted (a structure including the chips and the substrate) to the outside of the system. The transfer unit transfers the plurality of chips and the structure including the chips and the substrate between the carry-in/out unit, the chip supply device, the bonding device, and the surface processing device. In the chip supply device, a plurality of chips is produced by performing a dicing processing (paragraph [0248] of Patent Document 1). Also, in the chip supply device, the plurality of diced chips is disposed on a dicing tape (paragraph [0250] of Patent Document 1).

### PRIOR ART DOCUMENT

Patent Document 1: Japanese Patent No. 6337400

### DISCLOSURE OF THE INVENTION

### PROBLEMS TO BE SOLVED BY THE INVENTION

In view of the foregoing, an aspect of the present disclosure provides a technique capable of improving the quality of a chip-attached substrate.

### MEANS FOR SOLVING THE PROBLEMS

In one exemplary embodiment, a substrate processing apparatus includes a chip bonding device; a substrate cleaning device; a chip cleaning device; a transfer section; a first substrate transfer arm; and a first frame transfer arm. The chip bonding device is configured to bond the multiple chips to different bonding regions of a main surface of a substrate. The substrate cleaning device is configured to clean the substrate. The chip cleaning device is configured to clean multiple chips in a state where the multiple chips are attached to a frame via a tape. The transfer section is adjacent to the substrate cleaning device, the chip cleaning device, and the chip bonding device. The first substrate transfer arm is configured to hold and transfer the substrate in the transfer section. The first frame transfer arm is configured to hold the frame and transfer the frame together with the multiple chips in the transfer section. The first substrate transfer arm transfers the substrate from the substrate cleaning device to the chip bonding device, and the first frame transfer arm transfers the multiple chips together with the frame from the chip cleaning device to the chip bonding device.

### EFFECTS OF THE INVENTION

According to the aspects of the present disclosure, it is possible to improve the quality of the chip-attached substrate.

### BRIEF DESCRIPTION OF THE DRAWINGS

**FIG. 1** is a plan view illustrating a substrate processing apparatus according to an exemplary embodiment.
**FIG. 2A** is a cross-sectional view illustrating an example of a substrate, **FIG. 2B** is a cross-sectional view illustrating an example of a chip, **FIG. 2C** is a cross-sectional view illustrating an example of pickup of the chip, and FIG. **2D** is a cross-sectional view illustrating an example of a chip-attached substrate.
**FIG. 3** is a flowchart illustrating a substrate processing method according to the exemplary embodiment.
**FIG. 4A** is a plan view illustrating an example of an operation of a first frame transfer arm, and **FIG. 4B** is a plan view illustrating an example of an operation of the first frame transfer arm subsequent to the operation of **FIG. 4A****.**
**FIG. 5** is a cross-sectional view illustrating an example of a chip cleaning device.
**FIG. 6** is a cross-sectional view illustrating an example of an expanding device.
**FIG.** 7 is a cross-sectional view illustrating an example of a second processing station.
**FIG. 8** is a cross-sectional view illustrating an example of bonding of a dummy chip.
**FIG. 9** is a cross-sectional view illustrating an example of an inspection device.
**FIG. 10** is a cross-sectional view illustrating an example of a chip separation device.
**FIG. 11A** is a cross-sectional view illustrating an example of a blade, and **FIG. 11B** is a cross-sectional view illustrating an example of a heater and a cooler.
**FIG. 12A** is a cross-sectional view illustrating an example of a seal and a nozzle, and **FIG. 12B** is a cross-sectional view illustrating an example of a push-up pin.
**FIG. 13** is a cross-sectional view illustrating an example of a reworking device.
**FIG. 14** is a plan view illustrating a substrate processing apparatus according to a first modification example.
**FIG. 15** is a plan view illustrating a substrate processing apparatus according to a second modification example.
**FIG. 16A** is a cross-sectional view illustrating a modification example of the substrate shown in **FIG. 2A****,** **FIG. 16B** is a cross-sectional view illustrating an example of a second chip, **FIG. 16C** is a cross-sectional view illustrating an example of pickup of a second chip, and **FIG. 16D** is a cross-sectional view illustrating a modification example of the chip-attached substrate shown in **FIG. 2D****.**
**FIG. 17A** is a cross-sectional view illustrating another modification example of the chip-attached substrate shown in **FIG. 2D****,** **FIG. 17B** is a cross-sectional view illustrating an example of a post-processing on the chip-attached substrate shown in **FIG. 17A, FIG. 17C** is a cross-sectional view illustrating an example of a post-processing subsequent to the post-processing of **FIG. 17B,** and **FIG. 17D** is a cross-sectional view illustrating an example of a post-processing subsequent to the post-processing of **FIG. 17C****.**

### DETAILED DESCRIPTION

Hereinafter, exemplary embodiments of the present disclosure will be described with reference to the accompanying drawings. In each drawing, the same or corresponding components may be designated by the same reference numerals and descriptions thereof may be omitted. In the present disclosure, the X-axis direction, the Y-axis direction and the Z-axis direction are orthogonal to each other. The X-axis direction and the Y-axis direction are horizontal directions, and the Z-axis direction is a vertical direction.

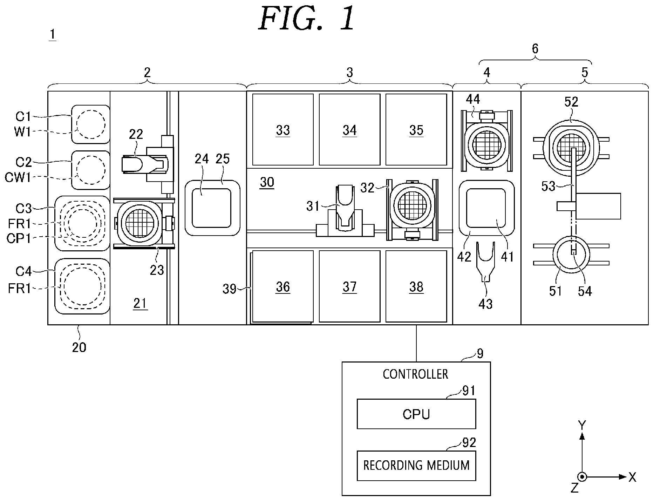

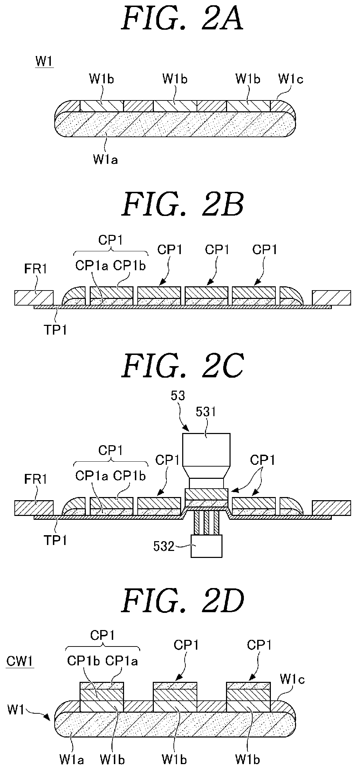

A substrate processing apparatus 1 according to an exemplary embodiment will be described with reference to **FIG. 1** and **FIG. 2A** to **FIG. 2D****.** As shown in **FIG. 2A** to **FIG. 2D****,** the substrate processing apparatus 1 is configured to manufacture a chip-attached substrate CW1 by bonding a plurality of chips CP1 to different bonding regions of a main surface W1c of a substrate W1. The bonding regions are previously set.

The chip-attached substrate CW1 includes the substrate W1 and the plurality of chips CP1 bonded to the substrate W1. Although not shown in the drawings, another chip may be stacked on each chip CP1.

The substrate W1 shown in **FIG. 2A** is carried into the substrate processing apparatus 1. The substrate W1 is equipped with a base substrate W1a and a plurality of devices W1b formed on the base substrate W1a. The base substrate W1a is, for example, a silicon wafer, a compound semiconductor wafer, or a glass substrate. The device W1b includes a semiconductor element, a circuit, or a terminal. The device W1b is formed on the main surface W1c.

Then, the plurality of chips CP1 shown in **FIG. 2B** is carried into the substrate processing apparatus 1. The plurality of chips CP1 is attached to a tape TP1, and an outer edge of the tape TP1 is attached to a frame FR1. The plurality of chips CP1 is arranged in an opening of the frame FR1. The plurality of chips CP1 is obtained by, for example, dicing a substrate being attached to the tape TP1.

The chip CP1 is equipped with a base substrate CP1a and a device CP1b formed on the base substrate CP1a. The base substrate CP1a is, for example, a silicon wafer, a compound semiconductor wafer, or a glass substrate. The device CP1b includes a semiconductor element, a circuit, or a terminal. The device CP1b is located opposite to the tape TP1 with respect to the base substrate CP1a.

As shown in **FIG. 2C****,** a pickup device 53 is configured to separate the plurality of chips CP1 individually from the tape TP1. Then, the chip CP1 is inverted and then bonded to the substrate W1 as shown in **FIG. 2D****.** The device W1b of the substrate W1 is electrically connected to the device CP1b of the chip CP1. As a result, the chip-attached substrate CW1 is obtained.

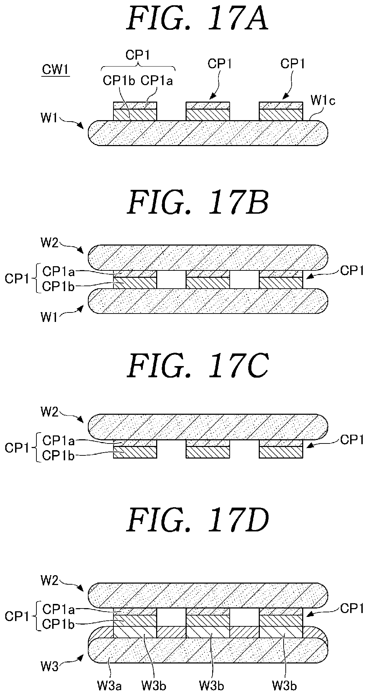

Further, as shown in **FIG. 17A****,** the substrate W1 constituting the chip-attached substrate CW1 may not include the device W1b. That is, the substrate W1 may not include an electrical circuit. For example, the substrate W1 is composed of only a silicon wafer, a compound semiconductor wafer, or a glass substrate. If the substrate W1 does not include the device W1b, the substrate W1 and a substrate W2 are bonded to each other with the plurality of chips CP1 interposed therebetween as shown in **FIG. 17B****.** Then, the plurality of chips CP1 and the substrate W1 are separated as shown in **FIG. 17C****,** and finally, the substrate W2 and a substrate W3 are bonded to each other with the plurality of chips CP1 interposed therebetween as shown in **FIG. 17D****.** The substrate W3 is equipped with a base substrate W3a and a plurality of devices W3b formed on the base substrate W3a. The device W3b of the substrate W3 is electrically connected to the device CP1b of the chip CP1.

As shown in **FIG. 1****,** the substrate processing apparatus 1 includes a carry-in/out station 2, a first processing station 3, an interface block 4, a second processing station 5, and a controller 9. The carry-in/out station 2, the first processing station 3, the interface block 4, and the second processing station 5 are arranged in this order from the negative X-axis direction toward the positive X-axis direction.

The carry-in/out station 2 is equipped with a placing table 20. Cassettes C1 to C4 are placed on the placing table 20. The cassette C1 accommodates therein the substrate W1 shown in **FIG. 2A****.** The cassette C2 accommodates therein the chip-attached substrate CW1 shown in **FIG. 2D****.** The cassette C3 accommodates therein the plurality of chips CP1 together with the frame FR1 shown in **FIG. 2B****.** The cassette C4 accommodates therein a non-illustrated frame FR1 which has been used. The frame FR1 which has been used refers to the frame FR1 remaining after the plurality of chips CP1 is separated from the tape TP1. The chip CP1 may remain on the frame FR1 which has been used.

The carry-in/out station 2 is equipped with a transfer section 21, a third substrate transfer arm 22, and a third frame transfer arm 23. The transfer section 21 is adjacent to the placing table 20. The third substrate transfer arm 22 is configured to hold and transfer the substrate W1 in the transfer section 21. The third frame transfer arm 23 is configured to hold and transfer the frame FR1 in the transfer section 21. The third substrate transfer arm 22 and the third frame transfer arm 23 are configured to be movable in horizontal directions (the X-axis direction and the Y-axis direction) and a vertical direction, and pivotable around a vertical axis.

The carry-in/out station 2 is equipped with a non-illustrated driver configured to move or rotate the third substrate transfer arm 22 and the third frame transfer arm 23. The third substrate transfer arm 22 and the third frame transfer arm 23 may be mounted on the same Y-axis slider and moved in the Y-axis direction at the same time. Alternatively, the third substrate transfer arm 22 and the third frame transfer arm 23 may be mounted on different Y-axis sliders and moved in the Y-axis direction independently of each other. If the third substrate transfer arm 22 and the third frame transfer arm 23 are mounted on the same Y-axis slider, they are stacked in the Z-axis direction. If the third substrate transfer arm 22 and the third frame transfer arm 23 are mounted on the different Y-axis sliders, the plurality of Y-axis sliders is arranged to be spaced from each other in the Z-axis direction.

The third substrate transfer arm 22 takes out the substrate W1, to which the chip CP1 has not yet been bonded, from the cassette C1, and transfers it to a substrate placing module 24. Also, the third substrate transfer arm 22 takes out the chip-attached substrate CW1 from the substrate placing module 24, and accommodates it in the cassette C2. The third substrate transfer arm 22 configured to transfer the substrate W1 to which the chip CP1 has not yet been bonded and the third substrate transfer arm 22 configured to transfer the chip-attached substrate CW1 may be provided separately.

The third frame transfer arm 23 takes out the plurality of chips CP1 together with the frame FR1 from the cassette C3, and transfers them to a frame placing module 25. Further, the third frame transfer arm 23 takes out the frame FR1, which has been used, from the frame placing module 25, and accommodates it in the cassette C4. The third frame transfer arm 23 configured to transfer the plurality of chips CP1 together with the frame FR1 and the third frame transfer arm 23 configured to transfer the frame FR1 which has been used may be provided separately.

The carry-in/out station 2 is equipped with the substrate placing module 24 and the frame placing module 25. The substrate placing module 24 and the frame placing module 25 are disposed between the transfer section 21 of the carry-in/out station 2 and a transfer section 30 of the first processing station 3 to be adjacent to both the transfer sections 21 and 30. The substrate placing module 24 and the frame placing module 25 may be stacked in the vertical direction to reduce a footprint of the carry-in/out station 2.

The substrate W1 to which the chip CP1 has not yet been bonded is placed in the substrate placing module 24. The chip-attached substrate CW1 may be placed in the substrate placing module 24. The substrate placing module 24 in which the substrate W1 to which the chip CP1 has not yet been bonded is placed and the substrate placing module 24 in which the chip-attached substrate CW1 is placed may be provided separately, and each of the substrate placing modules 24 may be plural in number.

The plurality of chips CP1 together with the frame FR1 are placed in the frame placing module 25. The frame FR1 which has been used may be placed in the frame placing module 25. The frame placing module 25 in which the plurality of chips CP1 together with the frame FR1 are placed and the frame placing module 25 in which the frame FR1 which has been used is placed may be provided separately, and each of the frame placing modules 25 may be plural in number.

The first processing station 3 is equipped with the transfer section 30, a first substrate transfer arm 31, and a first frame transfer arm 32. The transfer section 30 extends in the X-axis direction. The first substrate transfer arm 31 is configured to hold and transfer the substrate W1 in the transfer section 30. The first frame transfer arm 32 is configured to hold and transfer the frame FR1 in the transfer section 30. The first substrate transfer arm 31 and the first frame transfer arm 32 are configured to be movable in horizontal directions (the X-axis direction and the Y-axis direction) and a vertical direction, and pivotable around a vertical axis.

The first processing station 3 is equipped with a non-illustrated driver configured to move or rotate the first substrate transfer arm 31 and the first frame transfer arm 32. The first substrate transfer arm 31 and the first frame transfer arm 32 may be mounted on the same X-axis slider and moved in the X-axis direction at the same time. Alternatively, the first substrate transfer arm 31 and the first frame transfer arm 32 may be mounted on different X-axis sliders and moved in the X-axis direction independently of each other. If the first substrate transfer arm 31 and the first frame transfer arm 32 are mounted on the same X-axis slider, they are stacked in the Z-axis direction. If the first substrate transfer arm 31 and the first frame transfer arm 32 are mounted on the different X-axis sliders, the plurality of X-axis sliders is arranged to be spaced apart from each other in the Z-axis direction.

The first substrate transfer arm 31 takes out the substrate W1, to which the chip CP1 has not yet been bonded, from the substrate placing module 24, and transfers it to a first buffer module 41 of the interface block 4 via a surface modification device 34 and a substrate cleaning device 35. Also, the first substrate transfer arm 31 takes out the chip-attached substrate CW1 from the first buffer module 41, and places it in the substrate placing module 24 of the carry-in/out station 2 via an inspection device 36. The first substrate transfer arm 31 configured to transfer the substrate W1 to which the chip CP1 has not yet been bonded and the first substrate transfer arm 31 configured to transfer the chip-attached substrate CW1 may be provided separately.

The first frame transfer arm 32 takes out the plurality of chips CP1 together with the frame FR1 from the frame placing module 25, and transfers them to a second buffer module 42 of the interface block 4 via a chip cleaning device 33. Also, the first frame transfer arm 32 takes out the frame FR1, which has been used, from the second buffer module 42, and places it in the frame placing module 25 of the carry-in/out station 2. The first frame transfer arm 32 configured to transfer the plurality of chips CP1 together with the frame FR1 and the first frame transfer arm 32 configured to transfer the frame FR1 which has been used may be provided separately.

The first processing station 3 is equipped with the chip cleaning device 33, the surface modification device 34, the substrate cleaning device 35, the inspection device 36, a chip separation device 37, a reworking device 38, and an annealing device 39. The chip cleaning device 33, the surface modification device 34, the substrate cleaning device 35, the inspection device 36, the chip separation device 37, the reworking device 38, and the annealing device 39 are adjacent to the transfer section 30, and disposed on the positive side or negative side of the Y-axis direction of the transfer section 30.

The chip cleaning device 33 is configured to clean the plurality of chips CP1 in a state where the plurality of chips CP1 is attached to the tape TP1 and the outer edge of the tape TP1 is attached to the frame FR1. After the chips CP1 are cleaned, the chips CP1 are bonded to the substrate W1. Thus, it is possible to suppress entrainment of foreign matter. The chip cleaning device 33 will be described in detail below.

The surface modification device 34 is configured to process the main surface W1c of the substrate W1 with plasma. In the surface modification device 34, an oxygen gas as a processing gas is excited into plasma under, for example, a decompressed atmosphere to be ionized. As oxygen ions are radiated to the main surface W1c of the substrate W1, the main surface W1c is modified. The processing gas is not limited to the oxygen gas, and may be, for example, a nitrogen gas, or the like.

The substrate cleaning device 35 is configured to clean the main surface W1c of the substrate W1. For example, the substrate cleaning device 35 supplies pure water (e.g., deionized water) onto the substrate W1 while rotating the substrate W1 held by a spin chuck. The pure water spreads over the entire main surface W1c due to a centrifugal force, and cleans the main surface W1c. The pure water imparts OH groups to the modified main surface W1c. The chip CP1 can be bonded to the substrate W1 by a hydrogen bond between the OH groups.

The inspection device 36 is configured to inspect whether a bonding state of each of the plurality of chips CP1 bonded to the different bonding regions of the main surface W1c of the substrate W1 is good or bad. Inspection items include at least one of presence or absence of foreign matter, such as air bubbles, and presence or absence of misalignment. For example, if air bubbles are present on an interface between the substrate W1 and the chip CP1, the air bubbles implode when the chip-attached substrate CW1 is processed in a vacuum. The implosion of the air bubbles may cause a problem even in the chip CP1 whose bonding state is good, or contamination of a vacuum chamber. If the air bubbles or the particles are present on the interface between the substrate W1 and the chip CP1, the height of the chip CP1 is increased, and, thus, chipping occurs during grinding or polishing. Therefore, an impact generated by the chipping causes a problem even in the chip CP1 whose bonding state is good. The inspection device 36 will be described in detail below.

The chip separation device 37 is configured to separate, from the substrate W1, the chip CP1 whose bonding state has been determined to be bad in the inspection by the inspection device 36. Since the chip CP1 whose bonding state is bad is separated from the substrate W1, it is possible to solve the problem occurring when the air bubbles or the particles are present on the interface between the substrate W1 and the chip CP1. Therefore, it is possible to improve the quality of the chip-attached substrate CW1. The chip CP1 separated from the substrate W1 may be reused or discarded. The chip separation device 37 will be described in detail below.

The reworking device 38 is configured to selectively process a bonding region of the main surface W1c of the substrate W1 from which the chip CP1 has been separated by the chip separation device 37. The processing is performed to restore the bonding region from which the chip CP1 has been separated to a state right before the bonding of the chip CP1. For example, the reworking device 38 selectively supplies at least one of plasma or water to the bonding region from which the chip CP1 has been separated. The reworking device 38 will be described in detail below.

The annealing device 39 is configured to perform heat treatment on the chip-attached substrate CW1. Before the heat treatment, the chip CP1 is bonded to the substrate W1 by the hydrogen bond between OH groups. The heat treatment causes a dehydration condensation reaction, and a covalent bond is formed by the dehydration condensation reaction. Thus, bonding strength between the chip CP1 and the substrate W1 can be enhanced. Also, the separation of the chip CP1 by the chip separation device 37 is performed before the heat treatment on the chip-attached substrate CW1 by the annealing device 39.

The interface block 4 is adjacent to the transfer section 30 of the first processing station 3. The interface block 4 is equipped with the first buffer module 41, the second buffer module 42, a second substrate transfer arm 43, and a second frame transfer arm 44. The first buffer module 41 and the second buffer module 42 are adjacent to the transfer section 30 of the first processing station 3. The first buffer module 41 and the second buffer module 42 may be stacked in the vertical direction to reduce a footprint of the interface block 4.

The first buffer module 41 stores therein the substrate W1 to which the chip CP1 has not yet been bonded. The first buffer module 41 may store therein the chip-attached substrate CW1. The first buffer module 41 configured to store therein the substrate W1 to which the chip CP1 has not yet been bonded and the first buffer module 41 configured to store therein the chip-attached substrate CW1 may be provided separately, and each of the first buffer modules 41 may be plural in number.

The second buffer module 42 stores therein the plurality of chips CP1 together with the frame FR1. The second buffer module 42 may store therein the frame FR1 which has been used. The second buffer module 42 configured to store therein the plurality of chips CP1 together with the frame FR1 and the second buffer module 42 configured to store therein the frame FR1 which has been used may be provided separately, and each of the second buffer modules 42 may be plural in number.

The second substrate transfer arm 43 takes out the substrate W1, to which the chip CP1 has not yet been bonded, from the first buffer module 41, and transfers it to a substrate holder 51 of the second processing station 5. The second substrate transfer arm 43 may transfer the chip-attached substrate CW1 from the substrate holder 51 to the first buffer module 41. The second substrate transfer arm 43 is configured to be movable in horizontal directions (the X-axis direction and the Y-axis direction) and a vertical direction, and pivotable around a vertical axis. The second substrate transfer arm 43 configured to transfer the substrate W1 to which the chip CP1 has not yet been bonded and the second substrate transfer arm 43 configured to transfer the chip-attached substrate CW1 may be provided separately.

The second frame transfer arm 44 takes out the plurality of chips CP1 together with the frame FR1 from the second buffer module 42, and transfers them to a chip holder 52 of the second processing station 5. The second frame transfer arm 44 may transfer the frame FR1 which has been used from the chip holder 52 to the second buffer module 42. The second frame transfer arm 44 is configured to be movable in horizontal directions (the X-axis direction and the Y-axis direction) and a vertical direction, and pivotable around a vertical axis. The second frame transfer arm 44 configured to store therein the plurality of chips CP1 together with the frame FR1 and the second frame transfer arm 44 configured to transfer the frame FR1 which has been used may be provided separately.

The interface block 4 is equipped with a non-illustrated driver configured to move or rotate the second substrate transfer arm 43 and the second frame transfer arm 44. The second substrate transfer arm 43 and the second frame transfer arm 44 may be moved in a predetermined direction at the same time, or may be moved in the predetermined direction independently of each other. The second substrate transfer arm 43 and the second frame transfer arm 44 are not illustrated as being stacked in the Z-axis direction in **FIG. 1** and **FIG. 2A** to **FIG. 2D****,** but may be stacked in the Z-axis direction.

The interface block 4 stores therein the substrate W1 on which a pre-processing (e.g., surface modification and cleaning) has been performed and the plurality of chips CP1 on which a pre-processing (e.g., cleaning) has been performed. Thus, it is possible to improve the operation rate of the second processing station 5 and thus possible to improve the production efficiency of the chip-attached substrate CW1.

The interface block 4 may be omitted, and the first processing station 3 may be adjacent to the second processing station 5. In this case, the first substrate transfer arm 31 of the first processing station 3 transfers the substrate W1, to which the chip CP1 has not yet been bonded, to the substrate holder 51 of the second processing station 5, and receives the chip-attached substrate CW1 from the substrate holder 51. Further, in this case, the first frame transfer arm 32 of the first processing station 3 transfers the plurality of chips CP1 together with the frame FR1 to the chip holder 52 of the second processing station 5, and received the frame FR1 which has been used from the chip holder 52.

The second processing station 5 is located opposite to the transfer section 30 of the first processing station 3 with respect to the interface block 4. The second processing station 5 is equipped with the substrate holder 51, the chip holder 52, the pickup device 53, and a mounting device 54. The substrate holder 51 is configured to hold the substrate W1. The chip holder 52 is configured to hold the plurality of chips CP1 in a state where the plurality of chips CP1 is attached to the frame FR1 via the tape TP1. The substrate holder 51 and the chip holder 52 are configured to be movable in horizontal directions (the X-axis direction and the Y-axis direction), and pivotable around a vertical axis. The pickup device 53 is configured to separate the chip CP1 held by the chip holder 52 from the tape TP1. The mounting device 54 is configured to mount the chip CP1, which has been separated from the tape TP1 by the pickup device 53, on the main surface W1c of the substrate W1. The second processing station 5 will be described in detail below.

A chip bonding device 6 is composed of the interface block 4 and the second processing station 5. The chip bonding device 6 is adjacent to the transfer section 30 of the first processing station 3. Further, as described above, the interface block 4 may be omitted, and the chip bonding device 6 may be composed of only the second processing station 5.

The controller 9 is, for example, a computer, and includes a central processing unit (CPU) 91 and a recording medium 92, such as a memory. The recording medium 92 stores thereon a program for controlling various processings performed in the substrate processing apparatus 1. The controller 9 causes the CPU 91 to execute the program stored on the recording medium 92 to control an operation of the substrate processing apparatus 1.

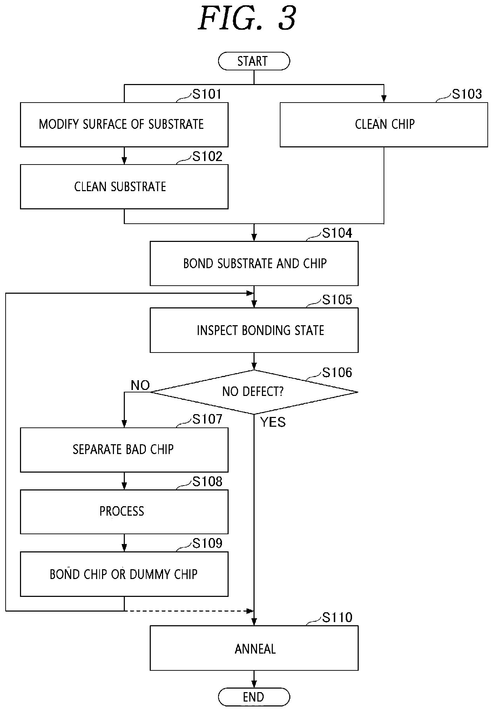

Referring to **FIG. 3****,** a substrate processing method according to the exemplary embodiment will be described. The processing shown in FIG. 3 is performed under the control of the controller 9.

First, the third substrate transfer arm 22 of the carry-in/out station 2 takes out the substrate W1 from the cassette C1, and transfers it to the substrate placing module 24. Then, the first substrate transfer arm 31 of the first processing station 3 takes out the substrate W1 from the substrate placing module 24, and transfers it to the surface modification device 34. Thereafter, the surface modification device 34 processes the main surface W1c of the substrate W1 with plasma (process S101). Then, the first substrate transfer arm 31 takes out the substrate W1 from the surface modification device 34, and transfers it to the substrate cleaning device 35. Thereafter, the substrate cleaning device 35 cleans the main surface W1c of the substrate W1 (process S102). Then, the first substrate transfer arm 31 takes out the substrate W1 from the substrate cleaning device 35, and transfers it to the first buffer module 41 of the interface block 4. Thereafter, the second substrate transfer arm 43 takes out the substrate W1 from the first buffer module 41, and transfers it to the substrate holder 51 of the second processing station 5.

The above-described processes are performed in parallel with the following processes. First, the third frame transfer arm 23 of the carry-in/out station 2 takes out the plurality of chips CP1 together with the frame FR1 from the cassette C3, and transfers them to the frame placing module 25. Then, the first frame transfer arm 32 of the first processing station 3 takes out the plurality of chips CP1 together with the frame FR1 from the frame placing module 25, and transfers them to the chip cleaning device 33. Thereafter, the chip cleaning device 33 cleans the plurality of chips CP1 (process S103). Then, the first frame transfer arm 32 takes out the plurality of chips CP1 together with the frame FR1 from the chip cleaning device 33, and transfers them to the second buffer module 42 of the interface block 4. Thereafter, the second frame transfer arm 44 takes out the plurality of chips CP1 together with the frame FR1 from the second buffer module 42, and transfers them to the chip holder 52 of the second processing station 5.

Then, the chip bonding device 6 bonds the plurality of chips CP1 to the different bonding regions of the main surface W1c of the substrate W1 (process S104). As a result, the chip-attached substrate CW1 is obtained. Thereafter, the second substrate transfer arm 43 takes out the chip-attached substrate CW1 from the substrate holder 51, and transfers it to the first buffer module 41. Then, the first substrate transfer arm 31 of the first processing station 3 takes out the chip-attached substrate CW1 from the first buffer module 41, and transfers it to the inspection device 36.

Thereafter, the inspection device 36 inspects whether the bonding state of each of the plurality of chips CP1 bonded to the different bonding regions of the main surface W1c of the substrate W1 is good or bad (process S105). The inspection device 36 transmits the inspection result to the controller 9. The controller 9 checks the presence or absence of defects (process S106). The controller 9 performs a control to distribute a transfer destination of the chip-attached substrate CW1 to the annealing device 39 and the chip separation device 37 according to the inspection result from the inspection device 36.

When the bonding state of the chip CP1 is bad (No in the process S106), the chip separation device 37 is the transfer destination of the chip-attached substrate CW1. The first substrate transfer arm 31 takes out the chip-attached substrate CW1 from the inspection device 36, and transfers it to the chip separation device 37. Then, the chip separation device 37 separates, from the substrate W1, the chip CP1 whose bonding state is bad (process S107). Thereafter, the first substrate transfer arm 31 takes out the chip-attached substrate CW1 from the chip separation device 37, and transfers it to the reworking device 38. Then, the reworking device 38 selectively processes the bonding region from which the chip CP1 has been separated (process S108). Thereafter, the first substrate transfer arm 31 takes out the chip-attached substrate CW1 from the reworking device 38, and transfers it to the chip bonding device 6.

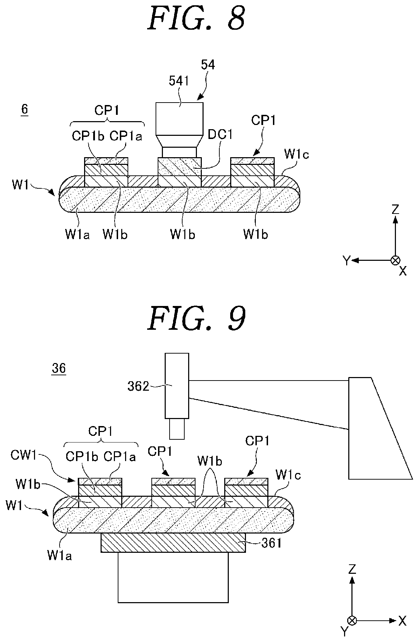

Then, the chip bonding device 6 bonds the chip CP1 again to the bonding region from which the chip CP1 has been separated, or bonds a dummy chip DC1 (see **FIG. 8**) separately provided from the chip CP1, without bonding the chip CP1 again, to the bonding region (process S109). Unlike the chip CP1, the dummy chip DC1 does not include a device, i.e., an electrical circuit. For example, the dummy chip DC1 is composed of only a silicon wafer, a compound semiconductor wafer, or a glass substrate. Alternatively, the chip bonding device 6 may bond neither the chip CP1 nor the dummy chip DC1 to the bonding region from which the chip CP1 has been separated, and may not bond anything to the bonding region.

When the chip CP1 is separated from the substrate W1, the device W1b of the substrate W1 may be damaged. It is a waste of the chip CP1 to bond the chip CP1 again to the damaged device W1b. If the chip CP1 is not bonded to the damaged device W1b, it is possible to suppress the waste of the chip CP1. This effect can be obtained even when nothing is bonded to the damaged device W1b.

Further, as shown in **FIG. 17A****,** if the substrate W1 does not include the device W1b, it is preferable to bond the chip CP1 again to the bonding region from which the chip CP1 has been separated. This is because if the chip CP1 is not bonded again to the bonding region (or the dummy chip DC1 is bonded again to the bonding region without bonding the chip CP1 again), it is a waste of the device W3b of the substrate W3 shown in **FIG. 17D****.**

As described above, the chip bonding device 6 bonds the chip CP1 again to the bonding region from which the chip CP1 has been separated, or bonds the dummy chip DC1 (process S109). In this case, unlike the case where nothing is bonded to the bonding region from which the chip CP1 has been separated, it is possible to suppress the chip-attached substrate CW1 from being subjected to a post-processing in a state where a space in which the chip CP1 is to be mounted is empty. Therefore, it is possible to improve the quality of the post-processing. For example, grinding or polishing can be uniformly performed.

After the process S109, the first substrate transfer arm 31 of the first processing station 3 takes out the chip-attached substrate CW1 from the chip bonding device 6, and transfers it to the inspection device 36. Then, the processings subsequent to the process S105 are repeatedly performed. Also, after the process S109, the first substrate transfer arm 31 may take out the chip-attached substrate CW1 from the chip bonding device 6, and transfer it to the annealing device 39. Then, processings subsequent to a process S110 are performed.

Meanwhile, when the bonding states of all the chips CP1 are not bad (Yes in the process S106), the annealing device 39 is the transfer destination of the chip-attached substrate CW1. The first substrate transfer arm 31 takes out the chip-attached substrate CW1 from the inspection device 36, and transfers it to the annealing device 39. Then, the annealing device 39 performs the heat treatment on the chip-attached substrate CW1 (process S110)). Due to the heat treatment, the bonding strength between the chip CP1 and the substrate W1 can be enhanced.

Thereafter, the first substrate transfer arm 31 takes out the chip-attached substrate CW1 from the annealing device 39, and places it in the substrate placing module 24 of the carry-in/out station 2. Finally, the third substrate transfer arm 22 of the carry-in/out station 2 takes out the chip-attached substrate CW1 from the substrate placing module 24, and accommodates it in the cassette C2. The chip-attached substrate CW1 being accommodated in the cassette C2 is carried out of the substrate processing apparatus 1.

After the process S104, the first frame transfer arm 32 of the first processing station 3 takes out the frame FR1 which has been used from the chip bonding device 6, and places it in the frame placing module 25 of the carry-in/out station 2. Then, the third frame transfer arm 23 of the carry-in/out station 2 takes out the frame FR1 which has been used from the frame placing module 25, and accommodates it in the cassette C4.

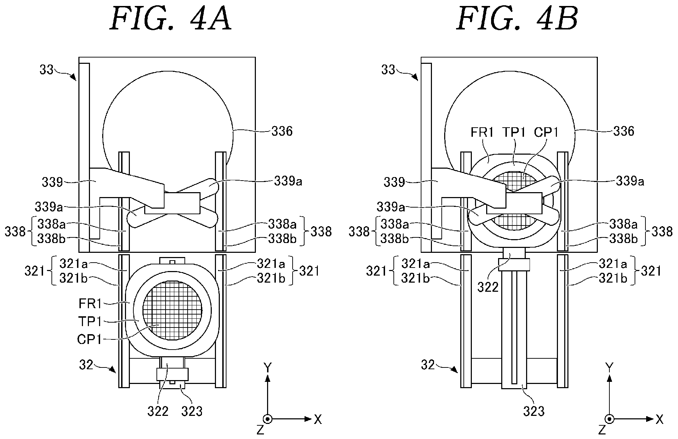

Hereinafter, an example of the first frame transfer arm 32 of the first processing station 3 will be described with reference to **FIG. 4A** and **FIG. 4B****.** The first frame transfer arm 32 is equipped with a pair of guide rails 321 on which the frame FR1 is mounted, a gripper 322 configured to grip the frame FR1, and a driver 323 configured to move the gripper 322 in a longitudinal direction of the pair of guide rails 321.

The third frame transfer arm 23 of the carry-in/out station 2 and the second frame transfer arm 44 of the interface block 4 may also have the same configuration as the first frame transfer arm 32 of the first processing station 3, and may be equipped with a pair of guide rails on which the frame FR1 is mounted, a gripper configured to grip the frame FR1, and a driver configured to move the gripper in a longitudinal direction of the pair of guide rails.

Each of the pair of guide rails 321 has an L-shaped cross section, and includes a horizontal plate 321a and a vertical plate 321b. When viewed from the top, a pair of vertical plates 321b are arranged with the frame FR1 interposed therebetween, and restrict a movement of the frame FR1 in a direction orthogonal to the vertical plate 321b. The frame FR1 is located on the pair of horizontal plate 321a.

The first frame transfer arm 32 is equipped with the pair of guide rails 321 as well as the gripper 322 and thus can stably support the frame FR1. Also, the driver 323 moves the gripper 322 in the longitudinal direction of the pair of guide rails 321 and thus can readily deliver the frame FR1 to a desired device (e.g., the chip cleaning device 33).

As shown in **FIG. 4A** and **FIG. 4B****,** the chip cleaning device 33 may be equipped with a pair of guide rails 338. The pair of guide rails 338 and the pair of guide rails 321 are consecutively arranged, and, thus, it is possible to readily deliver the frame FR1. The pair of guide rails 338 may be movable in the horizontal direction and the vertical direction.

Each of the pair of guide rails 338 has an L-shaped cross section, and includes a horizontal plate 338a and a vertical plate 338b. When viewed from the top, a pair of vertical plates 338b are arranged with the frame FR1 interposed therebetween, and restrict a movement of the frame FR1 in a direction orthogonal to the vertical plate 338b. The frame FR1 is located on the pair of horizontal plate 338a.

The chip cleaning device 33 may be equipped with an internal transfer device 339. As shown in **FIG. 4B****,** the internal transfer device 339 is configured to hold the frame FR1 from above and transfer it within the chip cleaning device 33. The internal transfer device 339 transfers the frame FR1 between the pair of guide rails 338 and a frame holder 332 to be described later.

The internal transfer device 339 is equipped with, for example, a plurality of arms 339a. When viewed from the top, the plurality of arms 339a is provided across an opening of the frame FR1, and transfers the frame FR1 while adsorbing the frame FR1 from above at both ends in the longitudinal direction. The internal transfer device 339 is configured to be movable in horizontal directions (the X-axis direction and the Y-axis direction) and a vertical direction.

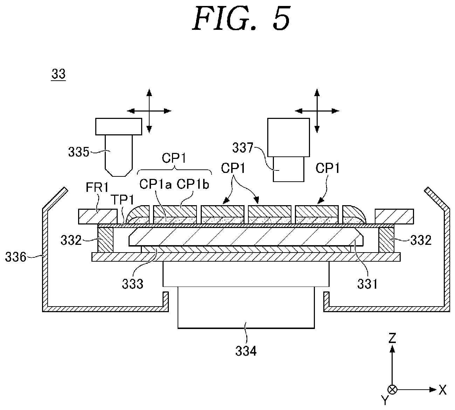

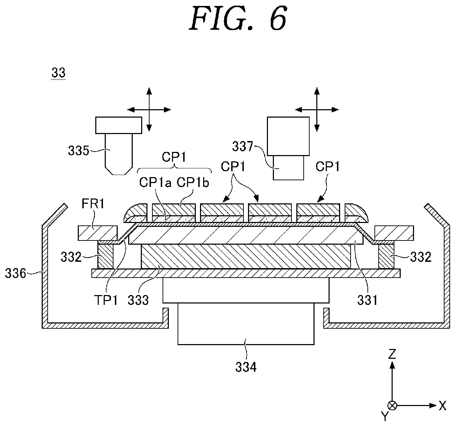

Hereinafter, an example of the chip cleaning device 33 will be described with reference to **FIG. 5** and **FIG. 6****.** The chip cleaning device 33 is equipped with, for example, a chip holder 331 and the frame holder 332. The chip holder 331 is configured to horizontally hold the plurality of chips CP1 from below via the tape TP1. If an expanding device 333 to be described later expands the tape TP1 in a radial shape, the chip holder 331 mounts thereon the tape TP1 to be slidable. Also, the chip holder 331 may be equipped with a vacuum chuck mechanism, and may fix the tape TP1.

The frame holder 332 is configured to horizontally hold the frame FR1 from below. The frame holder 332 is equipped with a vacuum chuck mechanism or a mechanical chuck mechanism, and fixes the frame FR1. A rotary driver 334 to be described later rotationally drives the frame holder 332, and, thus, the plurality of chips CP1 together with the frame FR1 is rotated.

The chip cleaning device 33 may be equipped with the expanding device 333. The expanding device 333 expands the tape TP1 in a radial shape as shown in FIG. 6 and thus increases a gap between the chips CP1 adjacent to each other. For example, the expanding device 333 moves the chip holder 331 upwards relatively to the frame holder 332 and thus expands the tape TP1 in the radial shape. By increasing the gap between the chips CP1 adjacent to each other, a lateral surface of the chip CP1 can be efficiently cleaned.

The chip cleaning device 33 may be equipped with the rotary driver 334, a nozzle 335, and a cup 336. The rotary driver 334 is configured to rotate the plurality of chips CP1 together with the frame FR1 by rotationally driving the frame holder 332. The rotary driver 334 rotationally drives the chip holder 331 together with the frame holder 332. The nozzle 335 is configured to supply a cleaning liquid to the plurality of chips CP1. The cleaning liquid is a chemical liquid or a rinse liquid. The rinse liquid is pure water, such as deionized water (DIW). The nozzle 335 may move in a direction orthogonal to a rotational center line of the chip holder 331 or the like. The cup 336 collects the cleaning liquid.

The chip cleaning device 33 may be equipped with a cleaning head 337. The cleaning head 337 is a brush or sponge, and scrub-cleans the plurality of chips CP1. The cleaning head 337 may apply ultrasonic waves to a liquid film formed between the cleaning head 337 and the plurality of chips CP1. The liquid film is formed when the nozzle 335 supplies the cleaning liquid.

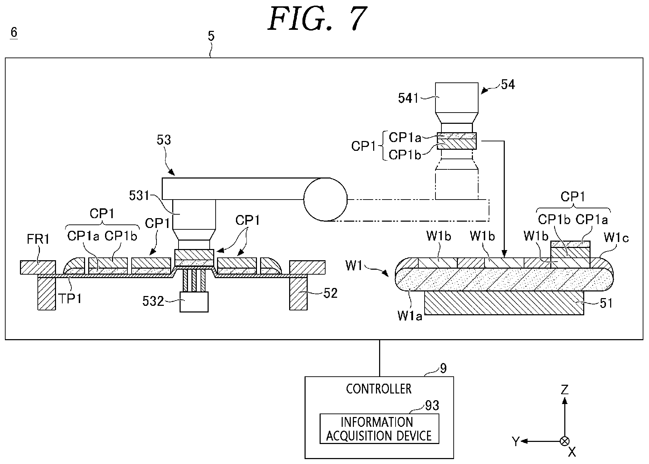

Hereinafter, an example of the second processing station 5 will be described with reference to **FIG. 7****.** As described above, the second processing station 5 is equipped with the substrate holder 51, the chip holder 52, the pickup device 53, and the mounting device 54.

The substrate holder 51 holds the substrate W1. For example, the substrate holder 51 horizontally holds the substrate W1 with the main surface W1c of the substrate W1 facing upwards. The main surface W1c of the substrate W1 may include the device W1b in each of the bonding regions, and the substrate holder 51 may hold the substrate W1 with the device W1b facing upwards.

The chip holder 52 holds the plurality of chips CP1 in a state where the plurality of chips CP1 is attached to the frame FR1 via the tape TP1. For example, the chip holder 52 horizontally holds the plurality of chips CP1 with the device CP1b of each of the plurality of chips CP1 facing upwards.

The pickup device 53 separates the plurality of chips CP1 individually from the tape TP1. The pickup device 53 is equipped with a first adsorption head 531. The first adsorption head 531 adsorbs the chip CP1 from a direction opposite to the tape TP1. For example, the first adsorption head 531 adsorbs the chip CP1 from above.

As the first adsorption head 531 moves upwards while adsorbing the chip CP1, the chip CP1 is separated from the tape TP1. The first adsorption head 531 can be inverted. When the chip CP1 is inverted, the chip CP1 may be mounted on the substrate W1 in a state where the device CP1b of the chip CP1 faces the substrate W1.

The chip holder 52 may be equipped with a push-up pin 532. The push-up pin 532 pushes up the chip CP1 from below via the tape TP1. The first adsorption head 531 adsorbs the chip CP1 pushed up by the push-up pin 532. Thus, it is possible to suppress interference between the chips CP1 adjacent to each other.

Although not illustrated, an expanding device may be provided in the pickup device 53, as in the chip cleaning device 33. The expanding device expands the tape TP1 in the radial shape and thus increases the gap between the chips CP1 adjacent to each other. Therefore, it is possible to suppress the interference between the chips CP1 adjacent to each other.

The mounting device 54 mounts the chip CP1 on the main surface W1c of the substrate W1 with the device CP1b of the chip CP1 facing the substrate W1. The mounting device 54 is equipped with a second adsorption head 541. The second adsorption head 541 adsorbs the inverted chip CP1 from above, and moves downwards in that state to mount the chip CP1 on the main surface W1c of the substrate W1.

Further, in the present exemplary embodiment, the second adsorption head 541 of the mounting device 54 directly receives the chip CP1 from the first adsorption head 531 of the pickup device 53, but may receive the chip CP1 via a non-illustrated transfer unit. The transfer unit transfers the chip CP1 from the pickup device 53 to the mounting device 54. The transfer unit may invert the chip CP1.

As shown in FIG. 7, if the main surface W1c of the substrate W1 includes the device W1b in each of the bonding regions, the controller 9 may include an information acquisition device 93. The information acquisition device 93 is configured to acquire information indicating whether a state of the device W1b in each of the bonding regions is good or bad. An external inspection device inspects whether the state of the device W1b is good or bad. The inspection device performs, for example, a visual inspection or an operation inspection on the device W1b, and transmits the inspection result to the controller 9.

The chip bonding device 6 bonds the chip CP1 to the device W1b whose state is good and bonds the dummy chip DC1 (see FIG. 8) to the device W1b whose state is bad under the control of the controller 9. Further, the chip bonding device 6 may bond neither the chip CP1 nor the dummy chip DC1 to the device W1b whose state is bad, and may not bond anything to the device W1b.

It is the waste of the chip CP1 to bond the chip CP1 to the device W1b whose state is bad. If the chip CP1 is not bonded to the device W1b whose state is bad, it is possible to suppress the waste of the chip CP1. This effect can be obtained even when nothing is bonded to the device W1b whose state is bad.

Also, if the dummy chip DC1 instead of the chip CP1 is bonded to the device W1b whose state is bad unlike the case where nothing is bonded to the device W1b whose state is bad, it is possible to suppress the chip-attached substrate CW1 from being subjected to the post-processing in the state where the space in which the chip CP1 is mounted is empty. Therefore, it is possible to improve the quality of the post-processing.

Hereinafter, an example of the inspection device 36 will be described with reference to **FIG. 9****.** The inspection device 36 inspects whether the bonding state of each of the plurality of chips CP1 bonded to the different bonding regions of the main surface W1c of the substrate W1 is good or bad. Inspection items include at least one of presence or absence of foreign matter, such as air bubbles, and presence or absence of misalignment. The inspection device 36 is equipped with, for example, a substrate holder 361 and an inspection head 362.

The substrate holder 361 is configured to hold the chip-attached substrate CW1. The substrate holder 361 is configured to be movable in horizontal directions (the X-axis direction and the Y-axis direction). The substrate holder 361 may be pivotable around a vertical axis. An inspection position may be changed by moving or rotating the substrate holder 361. The substrate holder 361 may be movable in a vertical direction.

The inspection head 362 is equipped with, for example, a computed tomography (CT) scanner, an infrared scanner, a confocal laser scanner, or an ultrasound scanner, and acquires an image of the interface between the chip CP1 and the substrate W1 to detect the presence or absence of air bubbles. Alternatively, the inspection head 362 may be equipped with a height meter, such as a laser displacement meter, and may detect the height of the chip CP1 to detect the presence or absence of air bubbles. If there are air bubbles, the height of the chip CP1 is increased by the thickness of the air bubbles.

The inspection device 36 may be equipped with a non-illustrated determination unit configured to determine whether the bonding state of each of the plurality of chips CP1 bonded to the different bonding regions of the main surface W1c of the substrate W1 is good or bad based on the information acquired by the inspection head 362. The determination unit is configured by a computer. The determination unit may be a part of the controller 9.

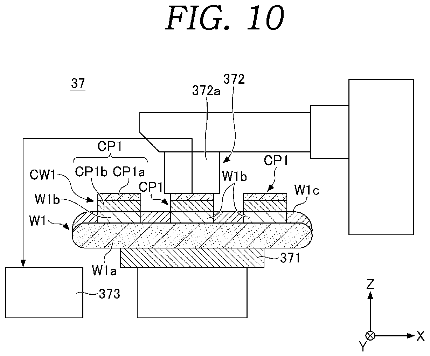

Hereinafter, an example of the chip separation device 37 will be described with reference to **FIG. 10****.** The chip separation device 37 separates, from the substrate W1, the chip CP1 whose bonding state has been determined to be bad in the inspection by the inspection device 36. The chip separation device 37 is equipped with, for example, a substrate holder 371, a separation head 372, and a recovery box 373.

The substrate holder 371 is configured to hold the chip-attached substrate CW1. The substrate holder 371 is configured to be movable in horizontal directions (the X-axis direction and the Y-axis direction). The substrate holder 371 may be pivotable around a vertical axis. A separation position may be changed by moving or rotating the substrate holder 371. The substrate holder 371 may be movable in a vertical direction.

The separation head 372 includes, for example, an adsorption head 372a. The adsorption head 372a adsorbs the chip CP1 from above, and moves upwards in that state to separate the chip CP1 from the substrate W1. The first adsorption head 531 may be movable in the horizontal directions as well as in the vertical direction. The adsorption head 372a drops the chip CP1 separated from the substrate W1 into the recovery box 373.

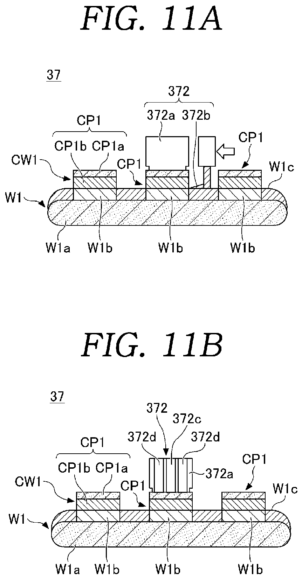

Hereinafter, modification examples of the chip separation device 37 will be described with reference to **FIG. 11A** to **FIG. 12B****.** As shown in **FIG. 11A****,** the separation head 372 may include a blade 372b as well as the adsorption head 372a. The blade 372b is inserted into the interface between the chip CP1 and the substrate W1 to separate the chip CP1 from the substrate W1.

As shown in **FIG. 11B****,** the separation head 372 may include a heater 372c and a cooler 372d as well as the adsorption head 372a. The heater 372c and the cooler 372d are provided within the adsorption head 372a to form a temperature gradient in the chip CP1 and separate the chip CP1 from the substrate W1 by a thermal stress.

The cooler 372d is disposed to surround the heater 372c. Thus, it is possible to suppress a lateral leakage of heat from the heater 372c and thus possible to suppress heating of the chip CP1, which is not a separation target. Even when the positions of the cooler 372d and the heater 372c are reversed, the chip CP1 can be separated from the substrate W1 by the thermal stress. Also, the cooler 372d may be provided in the substrate holder 371 (see **FIG. 10**) instead of being provided within the adsorption head 372a.

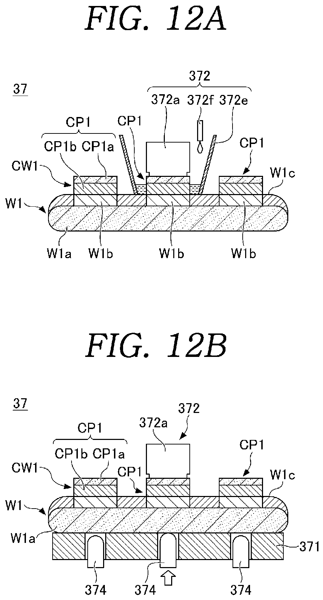

As shown in **FIG. 12A****,** the separation head 372 may include a tube-shaped seal 372e and a nozzle 372f as well as the adsorption head 372a. The seal 372e collects a separation liquid for reducing the bonding strength between the chip CP1 and the substrate W1 around the chip CP1, which is the separation target. The nozzle 372f is configured to discharge the separation liquid to the inside of the seal 372e.

The separation liquid permeates into the interface between the chip CP1, which is the separation target, and the substrate W1 to reduce the bonding strength between the corresponding chip CP1 and the substrate W1. The separation liquid includes pure water, such as DIW. The pure water reduces the bonding strength between the chip CP1 and the substrate W1 by hydrolysis. The separation liquid may include other components in addition to the pure water.

The seal 372e is pressed against the main surface W1c of the substrate W1. The seal 372e is formed of, for example, resin or rubber. An inner circumferential surface of the seal 372e may be tapered downwards. The tapered surface can guide the separation liquid to the inside thereof.

The nozzle 372f may suck up the separation liquid collected inside the seal 372e before the seal 372e is separated from the substrate W1. The nozzle 372f configured to discharge the separation liquid and the nozzle 372f configured to suck up the separation liquid may be provided separately.

As shown in **FIG. 12B****,** the chip separation device 37 may include a plurality of push-up pins 374 within the substrate holder 371. The plurality of push-up pins 374 is individually moved up and down. The push-up pins 374 locally push up the substrate W1 in a state where the substrate holder 371 adsorbs the chip-attached substrate CW1, and, thus, the substrate W1 is locally bending-deformed and the chip CP1 is separated from the substrate W1.

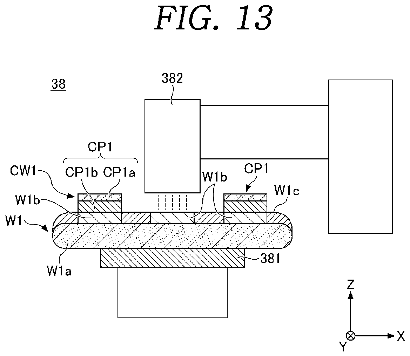

Hereinafter, an example of the reworking device 38 will be described with reference to **FIG. 13****.** The reworking device 38 selectively processes the bonding region of the main surface W1c of the substrate W1 from which the chip CP1 has been separated by the chip separation device 37. The reworking device 38 is equipped with, for example, a substrate holder 381 and a processing head 382.

The substrate holder 381 is configured to hold the chip-attached substrate CW1. The substrate holder 381 is configured to be movable in horizontal directions (the X-axis direction and the Y-axis direction). The substrate holder 381 may be pivotable around a vertical axis. A processing position may be changed by moving or rotating the substrate holder 381. The substrate holder 381 may be movable in a vertical direction.

The processing head 382 is equipped with, for example, a plasma head, and the plasma head selectively supplies plasma to the bonding region from which the chip CP1 has been separated. The processing head 382 may be equipped with a cover surrounding the plasma head to narrow a plasma supply region, and may reduce a pressure inside the cover.

The processing head 382 may be equipped with a cleaning head, and the cleaning head selectively supplies water to the bonding region from which the chip CP1 has been separated. The cleaning head may supply the water in one of a liquid state and a gas state. Preferably, the cleaning head supplies the water in the gas state. The processing head 382 may be equipped with a cover surrounding the cleaning head to narrow a water supply region, and may reduce a pressure inside the cover.

The processing head 382 may be movable in horizontal directions (the X-axis direction and the Y-axis direction). A processing position may be changed by moving the processing head 382. The processing head 382 may be movable in a vertical direction.

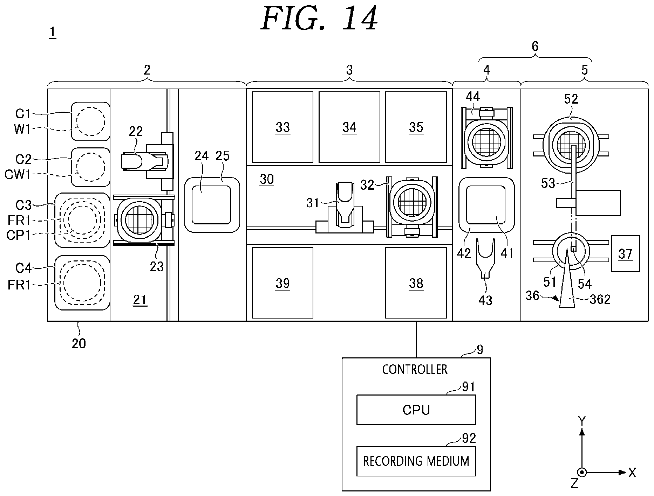

Hereinafter, the substrate processing apparatus 1 according to a first modification example will be described with reference to **FIG. 14****,** and the description will mainly focus on differences from the above-described exemplary embodiment. In the substrate processing apparatus 1, the second processing station 5 instead of the first processing station 3 includes the inspection device 36. The bonding of the substrate W1 and the chip CP1 (process S104) and the inspection of the bonding state (process S105) can be performed at the same time. The second processing station 5 instead of the first processing station 3 may include the chip separation device 37 as well as the inspection device 36.

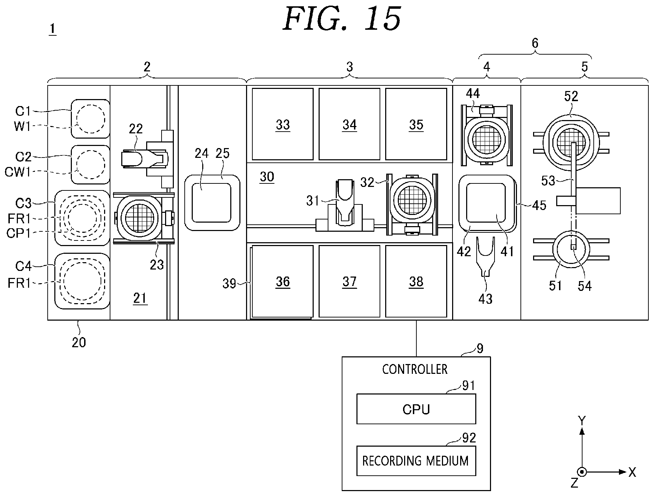

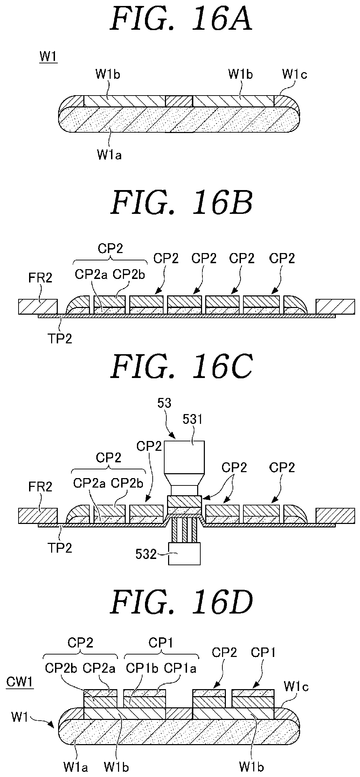

Hereinafter, the substrate processing apparatus 1 according to a second modification example will be described with reference to **FIG. 15** to **FIG. 16D****,** and the description will mainly focus on differences from the above-described exemplary embodiment and first modification example. As shown in **FIG. 16A** to **FIG. 16D****,** the substrate processing apparatus 1 manufactures a chip-attached substrate CW1 by bonding a second chip CP2, which is different from the chip CP1, to a second bonding region, which is different from the bonding region of the main surface W1c of the substrate W1. The chip-attached substrate CW1 includes the substrate W1, the plurality of chips CP1 bonded to the substrate W1, and the plurality of second chips CP2 bonded to the substrate W1.

The plurality of second chips CP2 shown in **FIG. 16B** is carried into the substrate processing apparatus 1. The plurality of second chips CP2 is attached to a second tape TP2, and an outer edge of the second tape TP2 is attached to a second frame FR2. The plurality of second chips CP2 is arranged in an opening of the second frame FR2. The plurality of second chips CP2 is obtained by, for example, dicing a substrate being attached to the second tape TP2.

The second chip CP2 is equipped with a base substrate CP2a and a device CP2b formed on the base substrate CP2a. The base substrate CP2a is, for example, a silicon wafer, a compound semiconductor wafer, or a glass substrate. The device CP2b includes a semiconductor element, a circuit, or a terminal. The device CP2b is located opposite to the second tape TP2 with respect to the base substrate CP2a.

As shown in **FIG. 16C****,** the pickup device 53 separates the plurality of second chips CP2 individually from the second tape TP2. Then, the second chip CP2 is inverted and then bonded to the substrate W1 as shown in **FIG. 16D****.** The device W1b of the substrate W1, the device CP1b of the chip CP1, and the device CP2b of the second chip CP2 are electrically connected to each other. As a result, the chip-attached substrate CW1 is obtained.

As shown in **FIG. 15****,** the interface block 4 may be equipped with a third buffer module 45. The third buffer module 45 is adjacent to the transfer section 30 of the first processing station 3. The first buffer module 41, the second buffer module 42, and the third buffer module 45 may be stacked in the vertical direction to reduce the footprint of the interface block 4.

The third buffer module 45 stores therein the plurality of second chips CP2 together with the second frame FR2. The third buffer module 45 stores therein the plurality of second chips CP2 on which a pre-processing (e.g., cleaning) has been performed. Thus, it is possible to improve the operation rate of the second processing station 5 and thus possible to improve the production efficiency of the chip-attached substrate CW1.

Also, the second chip CP2 is transferred and cleaned in the same manner as the chip CP1, and, thus, the redundant description thereof will be omitted. The second chip CP2 and the chip CP1 may be transferred and cleaned by the same device or by separate devices.

Further, the second chip CP2 is picked up and mounted in the same manner as the chip CP1, and, thus, the redundant description thereof will be omitted. The second chip CP2 and the chip CP1 may be picked up and mounted by the same device or by separate devices.

Although the exemplary embodiments of the substrate processing apparatus and the substrate processing method according to the present disclosure have been described above, the present disclosure is not limited to the above-described exemplary embodiments and the like. Various changes, modifications, substitutions, additions, deletions and combinations may be made within the scope of the claims. Of course, they also belong to the technical scope of the present disclosure.

### EXPLANATION OF CODES

1: Substrate processing apparatus
6: Chip bonding device
30: Transfer section
31: First substrate transfer arm
32: First frame transfer arm
33: Chip cleaning device
35: Substrate cleaning device
CP1: Chip
FR1: Frame
TP1: Tape
W1: Substrate
W1c: Main surface

## Claims

1. A substrate processing apparatus, comprising:
a substrate cleaning device configured to clean a substrate;
a chip cleaning device configured to clean multiple chips in a state where the multiple chips are attached to a frame via a tape;
a chip bonding device configured to bond the multiple chips to different bonding regions of a main surface of the substrate;
a transfer section adjacent to the substrate cleaning device, the chip cleaning device, and the chip bonding device;
a first substrate transfer arm configured to hold and transfer the substrate in the transfer section; and
a first frame transfer arm configured to hold the frame and transfer the frame together with the multiple chips in the transfer section,
wherein the first substrate transfer arm transfers the substrate from the substrate cleaning device to the chip bonding device, and the first frame transfer arm transfers the multiple chips together with the frame from the chip cleaning device to the chip bonding device.

2. The substrate processing apparatus of Claim 1,
wherein the chip cleaning device is equipped with an expanding device configured to expand the tape in a radial shape and increase a gap between the chips adjacent to each other.

3. The substrate processing apparatus of Claim 1 or 2,
wherein the chip cleaning device is equipped with a pair of guide rails configured to mount thereon the frame.

4. The substrate processing apparatus of any one of Claims 1 to 3,
wherein the chip bonding device is equipped with an interface block adjacent to the transfer section and a second processing station located opposite to the transfer section with respect to the interface block,
the second processing station is equipped with a substrate holder configured to hold the substrate, a chip holder configured to hold the multiple chips in the state where the multiple chips are attached to the frame via the tape, a pickup device configured to separate the chip held by the chip holder from the tape, and a mounting device configured to mount the chip, which is separated from the tape by the pickup device, on the substrate, and
the interface block is equipped with a first buffer module configured to store therein the substrate, which is transferred by the first substrate transfer arm, a second substrate transfer arm configured to transfer the substrate from the first buffer module to the substrate holder, a second buffer module configured to store therein the multiple chips, which are transferred together with the frame by the first frame transfer arm, and a second frame transfer arm configured to transfer the multiple chips together with the frame from the second buffer module to the chip holder.

5. The substrate processing apparatus of Claim 4,
wherein the chip bonding device bonds second chips, which are different from the chips, to second bonding regions, which are different from the bonding regions of the main surface of the substrate, and
the interface block is equipped with a third buffer module configured to store therein the multiple second chips in a state where the multiple second chips are attached to a second frame via a second tape.

6. The substrate processing apparatus of Claim 4 or 5,
wherein the second processing station is equipped with an inspection device configured to inspect whether a bonding state of each of the multiple chips bonded to the different bonding regions of the main surface of the substrate is good or bad, and a chip separation device configured to separate, from the substrate, the chip whose bonding state is determined to be bad in inspection by the inspection device.

7. The substrate processing apparatus of any one of Claims 1 to 5, further comprising:
an inspection device configured to inspect whether a bonding state of each of the multiple chips bonded to the different bonding regions of the main surface of the substrate is good or bad; and
a chip separation device configured to separate, from the substrate, the chip whose bonding state is determined to be bad in inspection by the inspection device,
wherein the inspection device and the chip separation device are adjacent to the transfer section.

8. The substrate processing apparatus of Claim 6 or 7,
wherein the chip bonding device bonds the chip again to the bonding region of the main surface of the substrate from which the chip is separated by the chip separation device, or does not bond the chip again to the bonding region.

9. The substrate processing apparatus of Claim 8,
wherein the chip bonding device does not bond the chip again to the bonding region of the main surface of the substrate from which the chip is separated by the chip separation device, but bonds a dummy chip, which is prepared separately from the chip, to the bonding region.

10. The substrate processing apparatus of any one of Claims 1 to 9,
wherein the main surface of the substrate includes a device in each of the bonding regions, and
wherein the substrate processing apparatus includes an information acquisition device configured to acquire information indicating whether a state of the device in each of the bonding regions is good or bad, and
the chip bonding device bonds the chip to the device whose state is good based on the information, and does not bond the chip to the device whose state is bad based on the information.

11. The substrate processing apparatus of Claim 10,
wherein the chip bonding device does not bond the chip to the device whose state is bad based on the information, but bonds a dummy chip, which is prepared separately from the chip, to the device.

12. The substrate processing apparatus of any one of Claims 1 to 11, further comprising:
a surface modification device configured to process the main surface of the substrate with plasma,
wherein the surface modification device is adjacent to the transfer section, and
the first substrate transfer arm transfers the substrate from the surface modification device to the substrate cleaning device.

13. The substrate processing apparatus of any one of Claims 1 to 12, further comprising:
a carry-in/out station adjacent to the transfer section and located opposite to the chip bonding device with respect to the transfer section,
wherein the carry-in/out station is equipped with a placing table configured to place thereon a cassette configured to accommodate therein the substrate to which the chip is not bonded and a cassette configured to accommodate therein the multiple chips in the state where the multiple chips are attached to the frame via the tape.

14. A substrate processing method of processing a substrate by using a substrate processing apparatus,
wherein the substrate processing apparatus includes:
a substrate cleaning device configured to clean the substrate;
a chip cleaning device configured to clean multiple chips in a state where the multiple chips are attached to a frame via a tape;
a chip bonding device configured to bond the multiple chips to different bonding regions of a main surface of the substrate;
a transfer section adjacent to the substrate cleaning device, the chip cleaning device, and the chip bonding device;
a first substrate transfer arm configured to hold and transfer the substrate in the transfer section; and
a first frame transfer arm configured to hold the frame and transfer the frame together with the multiple chips in the transfer section, and
wherein the substrate processing method includes:
cleaning the substrate by the substrate cleaning device;
transferring the substrate from the substrate cleaning device to the chip bonding device by the first substrate transfer arm;
cleaning the multiple chips by the chip cleaning device; and
transferring the multiple chips together with the frame from the chip cleaning device to the chip bonding device by the first frame transfer arm.

15. The substrate processing method of Claim 14, further comprising:
cleaning the multiple chips by the chip cleaning device in a state where the tape is expanded in a radial shape and a gap between the chips adjacent to each other is increased.

16. The substrate processing method of Claim 14 or 15,
wherein the chip bonding device is equipped with an interface block adjacent to the transfer section and a second processing station located opposite to the transfer section with respect to the interface block,
the second processing station is equipped with a substrate holder configured to hold the substrate, a chip holder configured to hold the multiple chips in the state where the multiple chips are attached to the frame via the tape, a pickup device configured to separate the chip held by the chip holder from the tape, and a mounting device configured to mount the chip, which is separated from the tape by the pickup device, on the substrate,
the interface block is equipped with a first buffer module configured to store therein the substrate, which is transferred by the first substrate transfer arm, a second substrate transfer arm configured to transfer the substrate from the first buffer module to the substrate holder, a second buffer module configured to store therein the multiple chips, which are transferred together with the frame by the first frame transfer arm, and a second frame transfer arm configured to transfer the multiple chips together with the frame from the second buffer module to the chip holder, and
wherein the substrate processing method further includes:
transferring the substrate from the first buffer module to the substrate holder by the second substrate transfer arm; and
transferring the multiple chips together with the frame from the second buffer module to the chip holder by the second frame transfer arm.

17. The substrate processing method of Claim 16,
wherein the interface block is equipped with a third buffer module configured to store therein multiple second chips in a state where the multiple second chips, which are different from the chips, are attached to a second frame via a second tape, and
wherein the substrate processing method further includes:
bonding the second chips to second bonding regions, which are different from the bonding regions of the main surface of the substrate, by the chip bonding device.

18. The substrate processing method of any one of Claims 14 to 17,
wherein the main surface of the substrate includes a device in each of the bonding regions, and
wherein the substrate processing method further includes:
acquiring information indicating whether a state of the device in each of the bonding regions is good or bad; and
bonding the chip to the device whose state is good based on the information, and not bonding the chip to the device whose state is bad based on the information.

19. The substrate processing method of Claim 18, further comprising:
bonding a dummy chip, which is prepared separately from the chip, to the device whose state is bad based on the information without bonding the chip to the device.
